# EUROPEAN PATENT SPECIFICATION

(11) **EP 0 684 082 B1**
(45) Date of publication and mention of the grant of the patent: **12.07.2000**
(21) Application number: 95107455.8
(22) Date of filing: 17.05.1995
(51) Int. Cl.: B05D 1/02, B32B 3/10

(54) **Reduced solvent island coating system**
Inselbeschichtungssystem mit verringertem Lösungsmittel
Système de couche insulaire avec solvant diminué

(30) Priority: 25.05.1994 US 248649
(43) Date of publication of application: 29.11.1995
(73) Proprietor: TEXTRON AUTOMOTIVE INTERIORS INC., Dover, New Hampshire 03820-1504 (US)
(72) Inventor: Lein, Maureen M., Chester, NH 03036 (US); Pelletier, Gary F., Dover, NH 03820 (US); Goad, Jeffrey Dale, Barboursville, WV 25504 (US); Lee, Chinsoo Stephen, Charleston, WV 25314 (US)
(74) Representative: Haecker, Walter, Dipl.-Phys.

(56) References cited:
- EP-A- 0 321 607
- US-A- 4 431 711
- US-A- 4 713 143
- US-A- 4 923 720
- US-A- 5 027 742
- US-A- 5 290 625

## Description

### TECHNICAL FIELD

This invention pertains to vacuum deposition of amphoteric materials.

### BACKGROUND OF THE INVENTION

Vacuum metallizing of plastic and similar dielectric substrates is disclosed in various forms including U.S. Patents:

| | |
|---|---|
| 2,992,125 | Fustier |
| 2,993,806 | Fisher |
| 3,118,781 | Downing |
| 3,914,472 | Nakanishi |
| 4,101,698 | Dunning |
| 4,131,530 | Blum |
| 4,211,822 | Kaufman |
| 4,215,170 | Oliva |

In addition, two reference books are:

Thin Film Phenomena, Kasturi L. Chopra, Robert E. Kreiger Publishing Company, Huntington, N.Y., 1979. pp. 163-189.

Handbook of Thin Film Technology, Leon I. Maissel and Reinhard Glang, McGraw-Hill Book Company, New York, N.Y., 1970., pp. 8-32 to 8-43.

U.S. Patents Nos. 4,407,871, 4,431,711 and 4,713,143, assigned to assignee of the present invention and incorporated herein by reference, relate to metallizing of plastic articles and more particularly to the structure and spacing of discrete metal islands used to metallize rather than a continuous metal film. The metallizing is performed utilizing the island coating system as detailed in the aforesaid patents. The system includes generally a primer and a basecoat coating layers, a metallizing layer and a topcoat layer. As disclosed in the above referenced patents, the coating layers contain non-volatile film forming polymers, generally in the range of 10-30%.

The most efficient way to deposit the coating layers of the island coating system is through a spray system. All of the coatings have been applied using a high volume, low pressure spray gun. However, such a system requires the use of organic solvents, generally at 70-90% by weight, as carriers for the coatings in order to be effectively deposited. If the mixture is not properly sprayed the aesthetic properties of the metallized appearance are not achieved. When the materials are sprayed, care must be taken to avoid gravitational flow of the material across the surface of the item being sprayed which can cause coating irregularities such as drips and runs. The material must be even, yet thick enough to cover surface irregularities and yet island formation must occur. Further, using this technology, film builds of 38 - 51 microns (1.5 to 2.0 mils) for any coating layer cannot be achieved without significant coating irregularities.

In addition to proper deposition of the coating layers, the appearance and performance of the commercial product, the conductivity of the metal layer, the corrosion resistance of the metal layer and/or the adhesion of the top coat all relate to the structure and spacing of the islands. The abovereferenced patents provide further teachings related to nucleation and film growth to the desired island structure and spacing that achieves these ends.

In United States patent 5,290,625, assigned to the assignee of the present invention and incorporated herein by reference, the above process is applied to aluminum parts. In a copending application, filed the same day as the instant application, assigned to the assignee of the present invention and incorporated herein by reference, the coating layers are modified to include a combined primer/basecoat layer.

U.S. Patent No. 4,431,711 shows the significant difference in performance to be obtained with a vacuum metallized flexible plastic product, top coated, where the metal particles are coalesced only to the island state instead of being allowed to coalesce as a thin continuous metallic film across which electrical conductivity is established.

The substrate is prepared for metallization by application of primer and basecoat layers in a solvent. The metal is vacuum deposited on the prepared substrate and the separate islands are coalesced from separate nucleation points and are globular or rounded and fused appearing and are part of the nucleation and growth process. The deposited islands are formed, in a preferred embodiment, by indium which is amphoteric and thus has some solubility in both acids and bases. As deposited, the indium metal layer is composed of tiny islands ranging from tiny clusters of 25 angstroms or less in diameter to sizes as large as 4,000 angstroms in diameter. Each of the islands is separated by channels which can be several hundred angstroms wide which produces the desired electrically non-conductive characteristics across the surface of the substrate.

In general, the spaces between the coalesced islands can be filled with the resin of the top coating applied in a solvent, in effect encapsulating the islands and binding them to the substrate surface. The rounded islands are better protected by the resin and the film overall is far more corrosion resistant, surprisingly so. The metal film is much more securely adhered to the substrate -- a very significant advantage.

The construction of the metal island structure in U.S. Patent No. 4,431,711 includes islands that are separated by channels which receive the top coat and allow the resinous film of the top coat to bond to the substrate for the indium island structures. The channels formed between the individual islands also contain many clusters and smaller islands of residual material. This material reduces the total effective area of substrate material to which the top coat can be bonded. Consequently, the resultant vacuum metallized article may be subject to undesirable delamination between the top coat and the substrate material.

U.S. Patent No. 4,713,143 adds to the process the step of etching the vacuum deposited material with a solvent which slowly dissolves or removes residual amounts of metal from the channels between the distinct islands. This clears the channels exposing additional bonding surfaces on the substrate for increasing the surface area of adhesion between the substrate and a protective dielectric top coat.

The typical adhesion strength of a top coat material to a base coat material is in the range of two orders of magnitude stronger than the adhesion strength of the top coat to the metal making up the individual island structures separated by the channels. The etch treatment step greatly improves the adhesion of top coat material of the type set forth in U.S. Patent No. 4,431,711.

While the flexible substrate described in U.S. Patent No. 4,431,711 has sufficient adhesion to pass most automotive specification tests, it is desirable to improve the adhesion in such articles so that it will consistently pass an X-scribed type taped adhesion test after either Florida exposures or accelerated weathering tests including QUV, weatherometer, xenon, dual carbon arc weatherometer. With increasing emphasis on quality in American made cars, such tests are now part of automotive specifications. By etching the island containing metal layers of the type described in U.S. Patent 4,431,711, an improved adhesion between top coat and base coat materials results so that such X-scribed standards can be met.

Weatherability now includes a requirement for resistance to acid rain. Acid rain is a low pH aqueous solution composed of several acids, primarily nitric and sulfuric acids. Rain drops which remain on the surface of the topcoat have the ability to permeate through the topcoat. As the droplets evaporate, the concentration of acid increases and is therefore more "aggressive". To improve resistance to acid rain, the thickness of the top coat must be increased, thereby reducing permeability. However, as the thickness of the top coat is increased flowout can become poor with its associated "orangepeel" appearance. Other coating irregularities such as drips and runs can occur. Further, "popping" (air entrapment) increases and gives an appearance that does not provide the aesthetic properties of the metallized appearance.

The current island coating system applies the polymeric constituents of the primer layer, basecoat layer and topcoat layer in organic solvent carriers such as glycol ethers, glycolether acetates, aromatic hydrocarbons and dibasic esters. These solvent carriers pose a waste disposal problem increasing the cost of production significantly. If the organic solvents could be eliminated, while still maintaining the aesthetic properties of the metallized appearance, significant savings as well as ease of waste disposal would be attained.

United States patent 4,923,720 to Lee et al, issued May 8, 1990 and assigned to the Union Carbide Chemicals and Plastics Company, Inc. and incorporated herein by reference, presents a further detailed discussion in columns 1 and 2 on the problems inherent in the use of organic solvent carriers.

Liquid inorganic carriers such as CO₂ can be substituted for organic solvent carriers as disclosed in U.S. Patent No. 4,923,720 to Lee et al. In converting gaseous inorganic carriers to the liquid state either pressure or pressure combined with increased temperature can be used to create a "supercritical" fluid or dense gas in which the polymer system is soluble. The utilization of pressure and increased temperature is expensive not only to produce but to maintain the gaseous inorganic carrier in a liquid state. If pressure alone is used to maintain such a liquid state, there is a further increase in temperature (Ideal Gas Law) that can adversely affect the stability of the polymeric constituents being carried by the liquified inorganic carrier. Additionally, as the pressurized polymeric material is circulated through the spray system, further instability can result.

U.S. Patent No. 4,923,720 to Lee et al. and U.S. Patent No. 5,027,742 issued on July 2, 1991 provide information for a system for use of supercritical fluids as diluents in spray coating.

U.S. Patent No. 5,027,742 and EP-A-0 321 607 disclose a process for the liquid spray application of coatings to a substrate wherein a liquid mixture comprising a polymeric compound capable of forming a coating on a substrate, a supercritical fluid, such as supercritical carbon dioxide fluid, and an organic solvent is sprayed onto a substrate to form a liquid coating thereon.

The system as taught in the above patents is marketed by Union Carbide as UNICARB®. Applicant has used the system, and modified the system as taught in the aforementioned patents, but the resulting coated products do not meet the required specifications for parts metallized using the island coating system. There was a variability in appearance of the parts and the UNICARB® system solvent blend was expensive to use.

The present invention relates to a process for manufacturing a metallized part according to the pre-characterizing portion of claim 1.

Such a process is known from U.S. Patent No. 4,431,711 wherein the metallized part is made from a thermoplastic olefin and the first coating layer is a primer layer.

It is the object of the invention to be able to use a non-organic or reduced organic solvent system such as the UNICARB® system to deliver the components of the island coating system producing uniform results at a reduced cost. Further, in utilizing such a system, it is necessary that coatings of 38 - 51 microns (1.5-2.0 mils) thickness be deposited without coating defects such as popping, drips, runs and sags.

### SUMMARY OF THE INVENTION AND ADVANTAGES

This object is achieved by a process as set forth in claim 1. Particular embodiments of the process according to the invention are set forth in claims 2 to 4.

According to the present invention, a process for manufacturing a metallized part using the island coating method, includes spray depositing a primer layer, basecoat layer, or a combined primer/basecoat layer each containing an increased amount of film forming polymer by using liquid CO₂ as a supplemental carrier along with a reduced amount of organic solvent carrier thereby reducing waste disposal costs and environmental concerns. Further, this modified island coating system can be used to deposit layers of 38 - 51 microns (1.5 to 2.0 mils thick) and maintain the aesthetic properties of the metallizing island coating system at a reduced cost and with minimal variability among parts.

### DETAILED DESCRIPTION OF THE PREFERRED EMBODIMENT

The present invention provides a process of manufacturing parts that have a metallized appearance, that reduces the amount of organic wastes and allows the spray deposition of coatings, without coating irregularities of up to 51 microns (2.0 mil) thickness.

The part can be made from a substrate material selected from the group consisting of thermoplastic urethanes, thermoplastic urethane alloys, polyester alloys, thermoplastic olefins and aluminum.

The island coating system is then applied as taught in U.S. Patents Nos. 4,407,871, 4,431,711 and 4,713,143 with the improvements disclosed in the present invention. In general, the island coating system includes generally either a combined primer/basecoat layer, or separate primer and basecoat layers, a metallizing layer and a topcoat layer. Each coating layer contains film forming polymers as disclosed in the above referenced patents.

In the practice of the present invention, the primer, basecoat and topcoat layers are applied using liquid CO₂ as a supplemental carrier along with a reduced amount of organic solvent blend carrier utilizing a noncirculating metering system which helps to maintain the stability of the components of each layer. In a preferred embodiment, a Unicarb™ system is the source of the liquid CO₂ and airless spray technology is used to apply the coatings.

To accommodate the liquid CO₂ as a carrier and maintain stability, the coating layers consist of a reduced solvent content of 50-70%, with 64% being the preferred embodiment. The solvent blend is comprised of xylene (20-25%), glycol ether acetates (60-80%) and dibasic ester (3-10%). The non-volatile film forming polymer of the coatings is increased from 10-30% by weight to 30-50% to accommodate the liquid CO₂ carrier. The percentage of CO₂ is 15-20% with 17% as the preferred embodiment.

The solvent blend taught by U.S. Patent No. 5,027,742 to Lee et al was found to be more expensive to use, even though a lower percentage was the recommended value. In the preferred embodiment of the present invention a cost savings of at least 10% in the cost of the solvent blend has been realized.

Neither the solvent blend percentage or CO₂ percentage are taught by U.S. Patent No. 5,027,742 to Lee et al to be the preferred values. It was unexpected to find a combination of non-preferred values that provided the optimum results to maintain the metallized appearance. In fact as shown in Table 1, hereinbelow, CO₂ percentage in the preferred range of 20-60% as taught by U.S. Patent No. 5,027,742 to Lee et al. did not provide an acceptable appearance. The formulation had to balance evaporation rates and solubility of polymeric material solvents.

The coatings are applied using airless spray technology (Nordson). The coatings are applied while the substrate is at ambient temperature.

The coatings are flashed for twenty minutes to evaporate the solvents in the coating followed by a curing step after application of each layer. Curing of each layer is done for 30 minutes at 127 °C (260°F).

In a preferred embodiment, the step of spray depositing is done while the part is being rotated as described in the co-pending application United States Serial Number 977,219, assigned to the assignee of the present invention, and incorporated herein by reference.

Certain parts may require the step of spray depositing to include spot sanding, or a full sanding, prior to application. In another embodiment, a further coating consisting of automotive exterior paint can be applied to the topcoat layer.

The resin and the solvent blend are mixed together and placed in a pressure pot for spraying. The coating and CO₂ are heated and then mixed with the resin-solvent blend mixture in a metered ratio just prior to spraying.

The invention will now be described by way of the following examples with it being understood that other advantages and a more complete understanding of the invention will be apparent to those skilled in the art from the detailed description of the invention.

### EXAMPLE 1

U.S. Patent No. 5,027,742 to Lee et al. teaches a preferred range of organic solvent blend of from 5 to 50% (column 6, lines 56-61), ranging as high as 70% with CO₂ being at 20-60 wt%. Samples were prepared and evaluated first for appearance and when appearance was satisfactory for adhesion, weatherability, chip resistance and for other automotive specification. To meet appearance standards no orangepeel, runs, drips, sags, pinholes, popping, or other detrimental appearance defects could be present.

Optimal results were obtained when the solvent blend was reduced to 64%, and CO₂ (Table 1) was at 17%. Neither of these values are in the preferred range taught by U.S. Patent No. 5,027,742 to Lee et al and other Union Carbide patents. It was unexpected to find a combination of non-preferred values that provided the optimum results to obtain the metallized appearance with the island coating system.

**TABLE 1**

| % CO | RESULTS |
|---|---|
| 12 | Poor flowout (orangepeel), popping |
| 13 | Poor flowout (orangepeel), popping |
| 14 | Poor flowout (orangepeel) |
| 15 | Marginally acceptable flowout (slight orange peel) |
| 16 | Good flowout |
| 17 | Good flowout |
| 18 | Good flowout |
| 19 | Good flowout |
| 20 | Good flowout |
| 21 | Acceptable flowout, some CO₂ entrapment which dissipates |
| 22 | CO₂ entrapment which causes some popping |

Using the above optimum system, in conjunction with airless spray technology (UNICARB® metering/spray equipment by Nordson), samples were evaluated at various film builds for a metallized appearance.

At all coating thicknesses tested from 38,1 to 50,8 microns (1.5 to 2.0 mils) coating thickness, the coatings of the present invention exhibited excellent flow and levelling with no evidence of popping. Further, these increased coating thicknesses appear to improve adhesion after weathering.

### EXAMPLE 2

### Permeability of the Topcoat

Acid rain resistance was measured as a function of moisture or water vapor permeability of the top coat layer.

### METHOD

Permeability tests were conducted in accordance with ASTM D 1653, "Test Method for Water Vapor Transmission of Organic Coating Films", Method A (Dry cup). Water vapor transmission rate (WVT) is measured in grains/foot² (929 cm²)/hour. Permeance is measured in grains/foot² (929 cm²)/hour/inch of mercury (3386 Pa) (perms). A perm rating of ≤1.0 indicates a vapor barrier coating. A perm value of >4.0 indicates a permeable coating.

Two tests were performed. In the first test (A) two moisture cured urethane clearcoat films were tested at film builds of 25,4 microns and 51 microns (1.0 and 2.0 mils). In a second test (B) six samples of 19.5 ; 36.6 ; 43.2 ; 53 ; 71 and 89 microns (0.769, 1.442, 1.7, 2.1, 2.8, and 3.5 mils) were tested.

| RESULTS | | | |
|---|---|---|---|
| Test A: | | | |
| | | 25,4 microns (1.0 mils) | 50,8 microns (2.0 mils) |
| Water Vapor Transmission Rate WVT grains/square foot (929 cm²)/hour | | 4.35 | 1.02 |
| Permeance - Perms WVP grains/square foot (929) cm²)/hour/inch of Mercury (3386 Pa) | | 9.18 | 2.15 |
| | | | |

| Test B: | | | |
|---|---|---|---|
| Microns (Mils) | WVT | Perms | |
| 19,5 (0.769) | 2.97 | 6.95 | |
| 36,6 (1.442) | 1.17 | 2.74 | |
| 43,2 (1.70) | 1.01 | 2.37 | |
| 53 (2.10) | 0.78 | 1.83 | |
| 71 (2.80) | 0.68 | 1.52 | |
| 89 (3.50) | 0.58 | 1.30 | |

### CONCLUSION

Permeability decreases in a non-linear manner as topcoat thickness increases, becoming asymptotic to 1.3 perms at 84 microns (3.3 mils) thickness. It was unexpected to find that the permeability of the topcoat in the island coating system decreases in a non-linear manner as topcoat thickness increases. Thicker topcoats will therefore be more resistant to acid rain injury than would have been predicted.

The invention has been described in an illustrative manner, and it is to be understood that the terminology which has been used is intended to be in the nature of words of description rather than of limitation.

Obviously, many modifications and variations of the present invention are possible in light of the above teachings. It is, therefore, to be understood that within the scope of the appended claims, the invention may be practiced otherwise than as specifically described.

## Claims

1. A process for manufacturing a metallized part comprising the steps of:
providing a part made from a material selected from the group consisting of thermoplastic urethanes, thermoplastic urethane alloys, polyester alloys, thermoplastic olefins and aluminum;
depositing on said part a first coating layer selected from the group consisting of a primer layer, basecoat layer and combined primer/basecoat layer by spray depositing a first coating material containing a film forming polymer and an organic solvent carrier;
vacuum depositing on said first coating layer a layer of corrosion prone metal material to form a discontinuous film covering said first coating layer and including a plurality of discrete islands of the corrosion prone metal material appearing macroscopically as a continuous film of such metal material and having a plurality of macroscopically unobservable channels between the islands to maintain the discontinuous film electrically non-conductive over the first coating layer, and
spray depositing on said discontinuous film a clear resinous dielectric protective topcoat layer containing a film forming polymer and an organic solvent carrier to completely cover said discontinuous film and filling said channels for bonding with the topcoat layer said metal material to said first coating layer throughout bottoms of said channels by an adhesion force greater than two orders of magnitude in strength as compared to the strength of the adhesion force between the topcoat layer and a continuous layer of said metal material;
characterized in that
the sprayed composition of the first coating material contains a non-volatile film forming polymer at 30 - 50 % by weight, an organic solvent carrier at 50 - 70 % by weight initially and liquid CO₂ as a supplemental carrier at 15 - 20 % by weight; and
the sprayed composition of the topcoat layer contains a non-volatile film forming polymer at 30 - 50 % by weight, an organic solvent carrier at 50 - 70 % by weight initially and liquid CO₂ as a supplemental carrier at 15 - 20 % by weight.

2. The process for manufacturing a metallized part as set forth in claim 1 wherein the primer, base, combined primer/basecoat and topcoat layer have a thickness in the range of 12,7 to 63,5 microns (0.5 mil to 2.5 mils) and can be the same or different.

3. The process for manufacturing a metallized part as set forth in claim 2 wherein the topcoat layer has a thickness of 50,8 microns (2.0 mils).

4. The process for manufacturing a metallized part as set forth in any of claims 1 to 3 wherein the sprayed composition of the first coating material and/or the sprayed composition of the topcoat layer contains an organic solvent carrier at 64 % by weight initially.

## Patentansprüche

1. Verfahren zum Herstellen eines metallisierten Teils, welches die folgenden Verfahrensschritte umfaßt:
Bereitstellen eines Teils, das aus einem Material hergestellt ist, welches aus der Gruppe ausgewählt ist, die aus thermoplastischen Urethanen, Mischungen von thermoplastischen Urethanen, Polyestermischungen, thermoplastischen Olefinen und Aluminium besteht;
Abscheiden einer ersten Überzugsschicht, die aus der Gruppe ausgewählt ist, welche aus einer Primer-Schicht, einer Grundschicht und einer kombinierten Primer-/Grundschicht besteht, auf dem Teil durch Zerstäubungsabscheiden eines ersten Beschichtungsmaterials, das ein filmbildendes Polymer und einen Träger eines organischen Lösungsmittels enthält;
Abscheiden einer Schicht eines korrosionsanfälligen Metallmaterials auf der ersten Überzugsschicht unter Vakuum, um einen unterbrochenen Film zu bilden, der die erste Überzugsschicht überdeckt und eine Mehrzahl getrennter Inseln des korrosionsanfälligen Metallmaterials umfaßt, welche makroskopisch als ein ununterbrochener Film eines solchen Metallmaterials erscheinen und eine Mehrzahl von makroskopisch nicht beobachtbaren Kanälen zwischen den Inseln aufweisen, um den unterbrochenen Film über der ersten Überzugsschicht elektrisch nicht leitfähig zu halten, und
Zerstäubungsabscheiden einer klaren harzhaltigen dielektrischen Schutzdeckschicht, die ein filmbildendes Polymer und einen Träger eines organischen Lösungsmittels enthält, auf dem unterbrochenen Film, um den unterbrochenen Film vollständig zu überdecken und die Kanäle zu füllen, um das Metallmaterial mit der Deckschicht überall an Böden der Kanäle an die erste Überzugsschicht zu binden mittels einer Adhäsionskraft, deren Stärke im Vergleich zu der Stärke der Adhäsionskraft zwischen der Deckschicht und einer ununterbrochenen Schicht des Metallmaterials mehr als zwei Größenordnungen größer ist;
dadurch gekennzeichnet, daß
die zerstäubte Zusammensetzung des ersten Beschichtungsmaterials zu 30 - 50 Gewichtsprozent ein nicht flüchtiges filmbildendes Polymer, zu anfänglich 50 - 70 Gewichtsprozent einen Träger eines organischen Lösungsmittels und zu 15 - 20 Gewichtsprozent flüssiges CO₂ als einen ergänzenden Träger enthält; und
die zerstäubte Zusammensetzung der Deckschicht zu 30 - 50 Gewichtsprozent ein nicht-flüchtiges filmbildendes Polymer, zu anfänglich 50 - 70 Gewichtsprozent einen Träger eines organischen Lösungsmittels und zu 15 - 20 Gewichtsprozent flüssiges CO₂ als einen ergänzenden Träger enthält.

2. Das Verfahren zum Herstellen eines metallisierten Teils nach Anspruch 1, wobei die Primer-Schicht, die Grundschicht, die kombinierte Primer-/Grundschicht und die Deckschicht eine Dicke in dem Bereich von 12,7 bis 63,5 µm (0,5 mil bis 2,5 mils) aufweisen und dieselben oder voneinander verschieden sein können.

3. Das Verfahren zum Herstellen eines metallisierten Teils nach Anspruch 2, wobei die Deckschicht eine Dicke von 50,8 µm (2,0 mils) aufweist.

4. Das Verfahren zum Herstellen eines metallisierten Teils nach einem der Ansprüche 1 bis 3, wobei die zerstäubte Zusammensetzung des ersten Beschichtungsmaterials und/oder die zerstäubte Zusammensetzung der Deckschicht zu anfänglich 64 Gewichtsprozent einen Träger eines organischen Lösungsmittels enthält.

## Revendications

1. Procédé de fabrication d'une pièce métallisée comprenant les étapes consistant à :
- fournir une pièce fabriquée à partir d'un matériau choisi dans le groupe se composant des uréthanes thermoplastiques, des alliages d'uréthanes thermoplastiques, des alliages de polyester, des oléfines thermoplastiques et de l'aluminium ;
- déposer sur ladite pièce une première couche de revêtement choisie dans le groupe se composant d'une couche d'apprêt, d'une couche de revêtement de base et d'une couche combinée d'apprêt et de revêtement de base en déposant par pulvérisation un premier matériau de revêtement contenant un polymère filmogène et un support de solvant organique ;
- déposer sous vide sur ladite première couche de revêtement une couche de matériau métallique ayant une tendance à la corrosion pour former un film discontinu recouvrant ladite première couche de revêtement et comprenant une pluralité d'îlots discrets du matériau métallique ayant une tendance à la corrosion apparaissant par observation macroscopique comme un film continu de ce matériau métallique et ayant une pluralité de canaux ne pouvant être observés à l'échelle macroscopique placés entre les îlots pour conserver le film discontinu électriquement non conducteur sur la première couche de revêtement, et
- déposer par pulvérisation sur ledit film discontinu une couche de finition protectrice diélectrique, résineuse et claire contenant un polymère filmogène et un support de solvant organique pour recouvrir entièrement ledit film discontinu et remplir lesdits canaux pour lier, avec la couche de finition, ledit matériau métallique à ladite première couche de revêtement au fond desdits canaux par une force d'adhérence supérieure aux deux ordres d'amplitude de résistance par rapport à la résistance de la force d'adhérence entre la couche de finition et une couche continue dudit matériau métallique ;
caractérisé en ce que
la composition pulvérisée du premier matériau de revêtement contient un polymère filmogène non volatil dans une proportion allant de 30 à 50 % en poids, un support de solvant organique dans une proportion allant de 50 à 70 % en poids initialement et du CO₂ liquide comme support supplémentaire dans une proportion allant de 15 à 20 % en poids ; et
la composition pulvérisée de la couche de finition contient un polymère filmogène non volatil dans une proportion allant de 30 à 50 % en poids, un support de solvant organique dans une proportion allant de 50 à 70 % en poids initialement et du CO₂ liquide comme support supplémentaire dans une proportion allant de 15 à 20 % en poids.

2. Procédé de fabrication d'une pièce métallisée selon la revendication 1, dans lequel la couche d'apprêt, de revêtement de base, d'apprêt et de revêtement de base combinée et de finition présentent une épaisseur de l'ordre de 12,7 à 63,5 µm (0,5 mil à 2,5 mils) et peuvent être identiques ou différents.

3. Procédé de fabrication d'une pièce métallisée selon la revendication 2, dans laquelle la couche de finition présente une épaisseur de 50,8 µm (2,0 mils).

4. Procédé de fabrication d'une pièce métallisée selon l'une quelconque des revendications 1 à 3, dans lequel la composition pulvérisée du premier matériau de revêtement et/ou la composition pulvérisée de la couche de finition contien(nen)t un support de solvant organique dans une proportion de 64 % en poids initialement.
